# EUROPEAN PATENT APPLICATION

(11) **EP 4 734 709 A1**
(43) Date of publication of application: **29.04.2026**
(21) Application number: 25167679.7
(22) Date of filing: 01.04.2025
(51) Int. Cl.: H10F 30/223, H10F 77/30

(54) **PHOTODIODE AND MANUFACTURING METHOD THEREOF**

(30) Priority: 25.10.2024 TW 113140909
(71) Applicant: Taiwan-Asia Semiconductor Corporation, Hsinchu City 30078 (TW)
(72) Inventor: Lin, Chun-Chieh, 30078 Hsinchu City (TW)
(74) Representative: Michalski Hüttermann & Partner Patentanwälte mbB

(57) **Abstract**

A photodiode and a manufacturing method thereof are provided. The photodiode comprises a first conductive type semiconductor layer, an intrinsic layer, a second conductive type semiconductor layer, and a silicide layer. The intrinsic layer is disposed on the first conductive type semiconductor layer and designed to generate a photocurrent in response to receiving a light of a specific wavelength. The second conductive type semiconductor layer is disposed on a central region of the intrinsic layer for exposing an outer peripheral region of the intrinsic layer surrounding the central region. The silicide layer is disposed at an edge of the outer peripheral region of the intrinsic layer to reduce a portion of the light that passes through the edge and enters the intrinsic layer for thereby preventing it from being absorbed by the intrinsic layer.

## Description

### CROSS-REFERENCES TO RELATED APPLICATIONS

This application claims the benefit of priority to Taiwanese Patent Application No. 113140909 filed on October 25, 2024, which is hereby incorporated by reference in its entirety.

### BACKGROUND OF THE INVENTION

### Field of the Invention

The present invention relates to a photodiode and a manufacturing method thereof, and in particular to a photodiode with high linearity for photodetection and a manufacturing method thereof.

### Descriptions of the Related Art

A photodiode is an electronic device designed to convert external optical signals into electrical signals. The core function of a photodiode lies in its ability to absorb external light for enabling the detection of optical signals and their conversion into measurable current. This conversion is critical for various applications, such as optical communication, optical measurement, and image generation.

The mechanism by which photodiodes absorb external light relies on the semiconductor materials within the diode (e.g., silicon substrate). When photons enter the photodiode and are absorbed, their energy excites electrons in the valence band to transition to the conduction band for generating electron-hole pairs. These photogenerated carriers are separated under the influence of the diode's built-in electric field and an electric current is generated correspondingly.

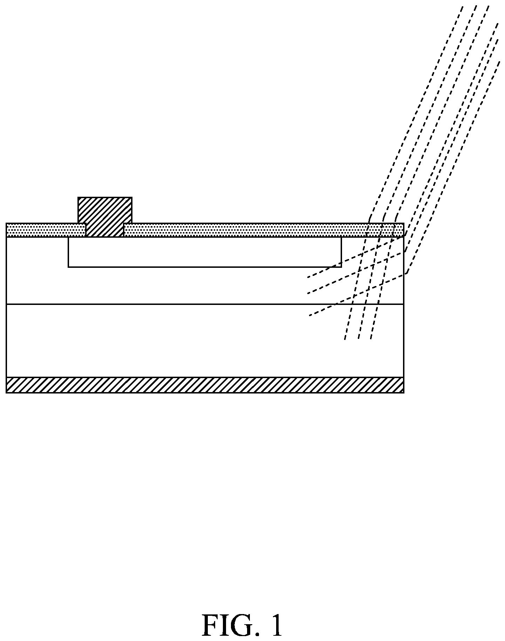

However, in practical applications of traditional photodiodes, external light can easily penetrate the exposed sidewalls of the device and lead to interference in internal operations. This interference degrades the linearity of the photodetector's performance and introduces computational errors in subsequent applications. As shown in FIG. 1, external light penetrating the exposed sidewalls of a conventional photodiode is concentrated at the edges of the device due to the refractive index (3.4) of the silicon substrate, which is significantly higher than the refractive index (1) of air. This phenomenon further affects the detection linearity of the photodiode.

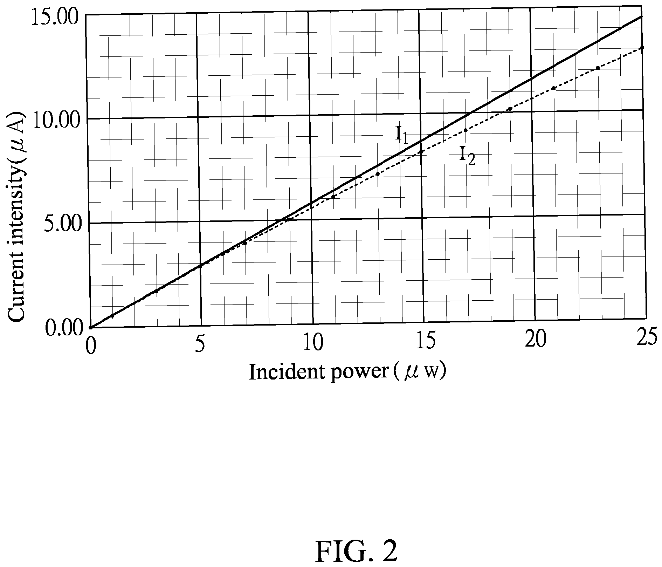

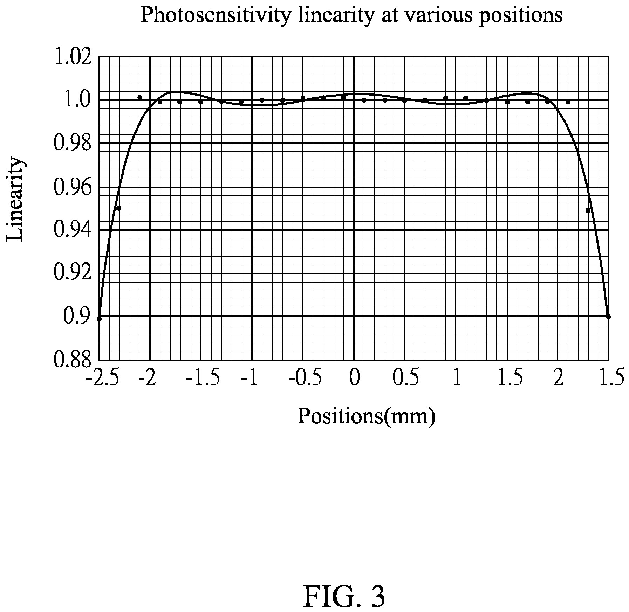

As illustrated in FIG. 2, line I; represents the photodiode's ideal linearity, wherein the current intensity generated by the photodiode maintains a linear relationship with the increasing power of incident external light. On the other hand, line I₂ represents the actual linearity between the incident light power and the corresponding current intensity under practical operating conditions. As shown in FIG. 2, as the incident power increases, the intensity of the electrical signal generated by the photodiode cannot maintain a linear growth relationship and exhibits a certain degree of attenuation. Additionally, as shown in FIG. 3, analyzing the linearity of the sensitivity across various positions within the photodiode reveals a stark contrast: the central region maintains high consistency in the linearity of its sensitivity, while the edge region experiences a sharp decline. To address these issues, there is an urgent need for an innovative photodiode structure to resolve the problem of inadequate linearity for its sensitivity caused by external light penetrating the device's sidewalls.

### SUMMARY OF THE INVENTION

The main objective of the present invention is to provide an innovative photodiode and its manufacturing method. Compared to conventional photodetector devices, the photodiode of the present invention features a silicide configured to be disposed at an upper edge thereof to reduce the concentration of external light entering the device through the edge and the sidewall thereof for thereby improving the linearity of photodiode's sensitivity and mitigating issues such as erroneous signals resulting from insufficient linearity.

To achieve the above objective, the present invention discloses a photodiode comprising a first conductive type semiconductor layer, an intrinsic layer, a second conductive type semiconductor layer, and a silicide layer. The intrinsic layer is disposed on the first conductive type semiconductor layer and designed to generate a photocurrent in response to receiving a light of a specific wavelength. The second conductive type semiconductor layer is disposed on a central region of the intrinsic layer for exposing an outer peripheral region of the intrinsic layer surrounding the central region. The silicide layer is disposed at an edge of the outer peripheral region of the intrinsic layer to reduce a portion of the light that passes through the edge and enters the intrinsic layer for thereby preventing it from being absorbed by the intrinsic layer.

In one embodiment of a photodiode of the present invention, the metal material of the silicide layer is selected from a group consisting of nickel (Ni), platinum (Pt), gold (Au), cobalt (Co), chromium (Cr), vanadium (V), titanium (Ti) and tungsten (W).

In one embodiment of a photodiode of the present invention, a depth of the silicide is no greater than one micrometer (µm).

In one embodiment of a photodiode of the present invention, a width of the silicide is substantially equal to one half of a width of the outer peripheral region of the intrinsic layer.

In one embodiment of a photodiode of the present invention, a thickness of the intrinsic layer is 50 to 70 micrometers (µm).

In one embodiment of a photodiode of the present invention, the intrinsic layer is an N type lightly doped silicon layer, doped with phosphorus (P), at the doping concentration of 10¹² to 10¹³ cm⁻³.

To achieve the above objective, the present invention discloses a manufacturing method of a photodiode comprising the following steps: providing a first conductive type semiconductor layer, providing an intrinsic layer disposed on the first conductive type semiconductor layer and configured to generate a photocurrent in response to receiving a light of a specific wavelength, providing a second conductive type semiconductor layer disposed on a central region of the intrinsic layer for exposing an outer peripheral region of the intrinsic layer surrounding the central region and providing a silicide layer disposed at an edge of the outer peripheral region of the intrinsic layer to reduce a portion of the light that passes through the edge and enters the intrinsic layer for thereby preventing it from being absorbed by the intrinsic layer.

In one embodiment of a method of manufacturing a photodiode of the present invention, the step of providing a silicide layer is a step of implanting and diffusing metal ions.

In one embodiment of a method of manufacturing a photodiode of the present invention, the metal material used in the step of implanting and diffusing metal ions is selected from a group consisting of nickel (Ni), platinum (Pt), gold (Au), cobalt (Co), chromium (Cr), vanadium (V), titanium (Ti) and tungsten (W).

In one embodiment of a method of manufacturing a photodiode of the present invention, the step of providing a silicide layer is to provide a nickel silicide layer with a depth no greater than one micrometer (µm).

In one embodiment of a method of manufacturing a photodiode of the present invention, the step of providing a silicide layer is to provide a nickel silicide layer with a width substantial equal to one half of a width of the outer peripheral region of the intrinsic layer.

In one embodiment of a method of manufacturing a photodiode of the present invention, the step of providing an intrinsic layer is to provide an N type lightly doped silicon layer, doped with phosphorus (P), at the doping concentration of 10¹² to 10¹³ cm⁻³.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram illustrating the concentration of light after external light enters the structure of a conventional photodiode.
FIG. 2 is a schematic diagram showing the linearity of the detection of a conventional photodiode under ideal conditions and during actual operation.
FIG. 3 is a schematic diagram depicting the linearity of the detection at various positions within a conventional photodiode.
FIG. 4 is a schematic diagram of a photodiode according to an embodiment of the present invention.
FIG. 5 is a schematic diagram illustrating the process steps of manufacturing a photodiode according to an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

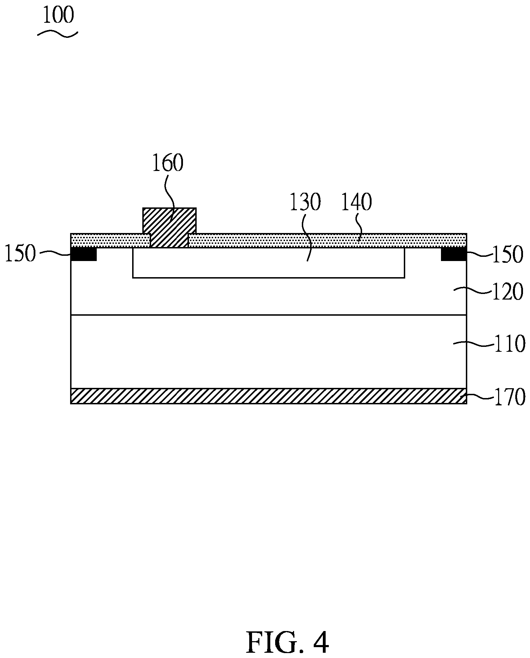

Refer to FIG. 4, which illustrates a schematic diagram of a photodiode in one embodiment of the present invention. In this embodiment, the photodiode 100 comprises a first conductive type semiconductor layer 110, an intrinsic layer 120, a second conductive type semiconductor layer 130, a protective layer 140, a silicide layer 150, an upper electrode 160, and a lower electrode 170. The first conductive type semiconductor layer 110 is a heavily doped N-type semiconductor layer, such as, but not limited to an antimony (Sb)-doped silicon wafer with a doping concentration of approximately 10¹⁸~10¹⁹ cm⁻³ and a thickness of approximately 70 to 80 micrometers (µm).The intrinsic layer 120 is a lightly doped semiconductor layer epitaxially formed on the first conductive type semiconductor layer 110, such as, but not limited to an N-type lightly doped epitaxial silicon layer doped with phosphorus (P) at a concentration of 10¹²~10¹³ cm⁻³. This layer is designed to generate an electrical signal in response to light of a specific wavelength. The thickness of the intrinsic layer 120 is typically tailored to the wavelength and application requirements of the light, as it is crucial for optimizing photoelectric conversion efficiency. In the present invention, the intrinsic layer 120 has a thickness of approximately 50 to 70 micrometers (µm), but not limited thereto.

Moreover, as shown in FIG. 4, the second conductivity type semiconductor layer 130 is disposed on a central region of the intrinsic layer 120 and leaves an outer peripheral region of the intrinsic layer 120 exposed. The second conductivity type semiconductor layer 130 is a P-type doped semiconductor layer, such as, but not limited to a boron (B)-doped silicon layer with a doping concentration of 10¹⁹~10²⁰ cm⁻³. The protective layer 140 typically functions as a band-pass filter covering the second conductivity type semiconductor layer 130 for selectively allowing light of a specific wavelength to pass through and be absorbed by the intrinsic layer 120, while blocking other wavelengths, such as visible or infrared light. The protective layer 140 is usually composed of stacked dielectric materials with alternating high and low refractive indices, such as silicon dioxide (SiO₂), titanium dioxide (TiO₂), or silicon nitride (Si₃N₄). In a preferred embodiment, the protective layer 140 further includes an anti-reflection layer formed on the band-pass filter layer, which enhances the transmittance of specific wavelengths of light, improves photon utilization, and minimizes reflection losses of incident light for thereby increasing the photoelectric conversion efficiency of the device. Meanwhile, the upper electrode 160, acting as the anode, is disposed on and electrically connected to the second conductivity type semiconductor layer 130, while the lower electrode 170, acting as the cathode, is disposed on the back side of the first conductivity type semiconductor layer 110 and electrically connected thereto. Both the upper electrode 160 and the lower electrode 170 are made of, but are not limited to, aluminum metal.

The photodiode 100 of the present invention is designed to overcome the issue of poor linearity in traditional photodiodes by specifically incorporating a silicide layer 150 disposed at the upper edge of the device structure, as shown in FIG 4. Specifically, the silicide layer 150 is disposed at the edge of the outer peripheral region of the intrinsic layer 120. More specifically, the silicide layer 150 can be formed using conventional metal silicide processes. For example, after the second conductive type semiconductor layer 130 is formed, a metal ion implantation and high-temperature diffusion process is performed on the surface of the edge of the outer peripheral region of the intrinsic layer 120. The metal material used for the ion implantation and diffusion process is selected from a group consisting of nickel (Ni), platinum (Pt), gold (Au), cobalt (Co), chromium (Cr), vanadium (V), titanium (Ti), and tungsten (W). This process forms a thin layer structure at the edge of the outer peripheral region of the intrinsic layer 120, with a depth of less than 1 micrometer (µm) from the upper surface of the intrinsic layer 120 and a width substantially equal to one half of the width of the outer peripheral region of the intrinsic layer 120. In a preferred embodiment, the silicide layer 150 may be a nickel silicide layer, a platinum silicide layer, a cobalt silicide layer, or the like.

The objective of incorporating the silicide layer in the photodiode of the present invention is to prevent external light from entering the device interior through the edges and sidewalls of the intrinsic layer. This design avoids the absorption of external light by the intrinsic layer at these regions, which could otherwise generate unintended photocurrents and adversely affect the linearity of the detection of the device. Compared to conventional photodiodes, the silicide layer 150 in the photodiode 100 of the present invention effectively blocks a portion of the external light passing through the edge regions. This reduces the issue of light concentration at the edges for thereby improving the linearity of the detection of the photodiode at the edge regions and addressing the problem of insufficient linearity at the device edges, as illustrated in FIG. 3.

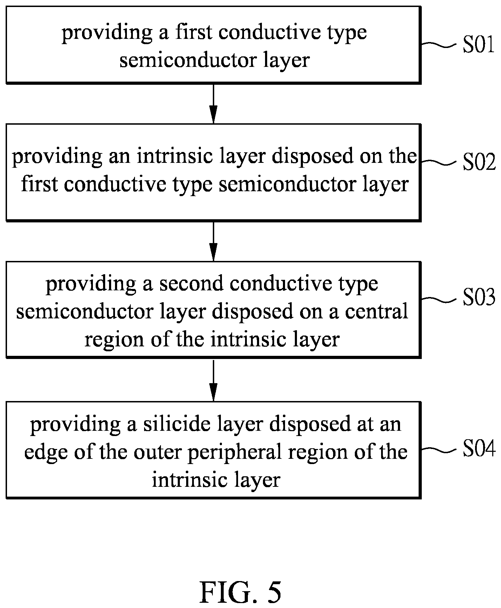

Refer to FIG. 5, which illustrates the process steps for fabricating the photodiode of the present invention. First, in step S01, a first conductive type semiconductor layer is provided. Next, in step S02, an intrinsic layer is provided and disposed on the first conductive type semiconductor layer, configured to generate a photocurrent in response to receiving a light of a specific wavelength. In step S03, a second conductive type semiconductor layer is provided, which is disposed on a central region of the intrinsic layer while exposing an outer peripheral region of the intrinsic layer surrounding the central region. Finally, in step S04, a silicide layer is provided and disposed at the edge of the outer peripheral region of the intrinsic layer to reduce the portion of the light that passes through the edge and enters the intrinsic layer from being absorbed by the intrinsic layer. The descriptions of the relevant components can be found in the preceding sections and will not be repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A photodiode, comprising:
a first conductive type semiconductor layer;
an intrinsic layer, disposed on the first conductive type semiconductor layer and configured to generate a photocurrent in response to receiving a light of a specific wavelength;
a second conductive type semiconductor layer, disposed on a central region of the intrinsic layer for exposing an outer peripheral region of the intrinsic layer surrounding the central region; and
a silicide layer, disposed at an edge of the outer peripheral region of the intrinsic layer to reduce a portion of the light that passes through the edge and enters the intrinsic layer for thereby preventing it from being absorbed by the intrinsic layer.

2. The photodiode of claim 1, wherein the metal material of the silicide layer is selected from a group consisting of nickel (Ni), platinum (Pt), gold (Au), cobalt (Co), chromium (Cr), vanadium (V), titanium (Ti) and tungsten (W).

3. The photodiode of any of the previous claims, wherein a depth of the silicide is no greater than one micrometer (µm).

4. The photodiode of any of the previous claims, wherein a width of the silicide is substantially equal to one half of a width of the outer peripheral region of the intrinsic layer.

5. The photodiode of claim 4, wherein a thickness of the intrinsic layer is 50 to 70 micrometers (µm).

6. The photodiode of any of the previous claims, wherein the intrinsic layer is an N type lightly doped silicon layer, doped with phosphorus (P), at the doping concentration of 10¹² to 10¹³ cm⁻³.

7. A manufacturing method of a photodiode, comprising:
providing a first conductive type semiconductor layer;
providing an intrinsic layer, disposed on the first conductive type semiconductor layer and configured to generate a photocurrent in response to receiving a light of a specific wavelength;
providing a second conductive type semiconductor layer, disposed on a central region of the intrinsic layer for exposing an outer peripheral region of the intrinsic layer surrounding the central region; and
providing a silicide layer, disposed at an edge of the outer peripheral region of the intrinsic layer to reduce a portion of the light that passes through the edge and enters the intrinsic layer for thereby preventing it from being absorbed by the intrinsic layer.

8. The manufacturing method of a photodiode of claim 7, wherein the step of providing a silicide layer is a step of implanting and diffusing metal ions.

9. The manufacturing method of a photodiode of claim 8, wherein the metal material used in the step of implanting and diffusing metal ions is selected from a group consisting of nickel (Ni), platinum (Pt), gold (Au), cobalt (Co), chromium (Cr), vanadium (V), titanium (Ti) and tungsten (W).

10. The manufacturing method of a photodiode of any of the previous manufacturing claims, wherein the step of providing a silicide layer is to provide a nickel silicide layer with a depth no greater than one micrometer (µm).

11. The manufacturing method of a photodiode of any of the previous manufacturing claims, wherein the step of providing a silicide layer is to provide a nickel silicide layer with a width substantial equal to one half of a width of the outer peripheral region of the intrinsic layer.

12. The manufacturing method of a photodiode of any of the previous manufacturing claims, wherein the step of providing an intrinsic layer is to provide an N type lightly doped silicon layer, doped with phosphorus (P), at the doping concentration of 10¹² to 10¹³ cm⁻³.
